Europäisches Patentamt

European Patent Office

Office européen des brevets

(11) Publication number: **0 674 395 A2**

# EUROPEAN PATENT APPLICATION

(21) Application number: **95300461.1**

(22) Date of filing: **26.01.95**

(51) Int. Cl.6: **H03M 13/00**

(30) Priority: **17.03.94 JP 47467/94**
**28.03.94 JP 57814/94**

(43) Date of publication of application:
**27.09.95 Bulletin 95/39**

(84) Designated Contracting States:
**DE FR GB NL**

(71) Applicant: **KABUSHIKI KAISHA TOSHIBA**
**72, Horikawa-cho,**
**Saiwai-ku**
**Kawasaki-shi,**
**Kanagawa-ken 210,**
**Tokyo (JP)**

(72) Inventor: **Hirayama, Koichi, c/o Intellectual**
**Property Div.**
**K. K. Toshiba,**
**1-1, Shibaura 1-chome,**
**Minato-ku**
**Tokyo (JP)**
**Inventor: Kojima, Tadashi, c/o Intellectual**
**Property Div.**
**K. K. Toshiba,**
**1-1, Shibaura 1-chome,**
**Minato-ku**
**Tokyo (JP)**
**Inventor: Yoneda, Minoru, c/o Intellectual**
**Property Div.**
**K. K. Toshiba,**
**1-1, Shibaura 1-chome,**
**Minato-ku**
**Tokyo (JP)**

(74) Representative: **Maury, Richard Philip**
**MARKS & CLERK,**
**57-60 Lincoln's Inn Fields**
**London WC2A 3LS (GB)**

(54) Error correction code encoding device and error correction code encoding method.

(57) An original data packet composed of (k x m - po) symbols x n lines is added to first parity symbols composed of po symbols x n lines and thereby a first error correction code sequence composed of (k x m) symbols x n lines is formed. Matrix symbols of the first error correction code sequence are divided into k blocks, each of which is composed of m symbols x n lines. The k divided blocks are positioned as diagonal element blocks of a block matrix composed of k blocks x k lines. While a first encoding process and a block positioning process are being performed for a plurality of original data packets to be transmitted in succession, second parity symbols composed of pi symbols x n lines are added to the matrix composed of (k x m) symbols x n lines and thereby a second error correction code sequence composed of (k x m + pi) symbols x n lines is formed.

FIG. I

The present invention relates to an error correction code encoding device applicable for recording and reproducing digital data.

Error correction systems have been used for transmitting and recording digital data. In one system, an error correction code (such as Reed Solomon code) is transformed into a product code. In another system, after or before a product code forming process is performed, data is interleaved.

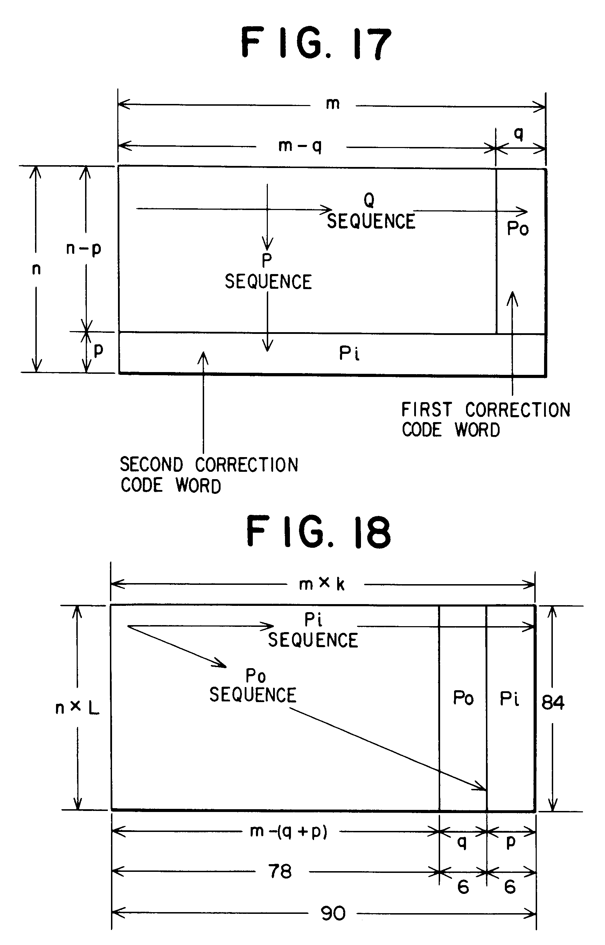

Fig. 17 is a schematic diagram showing an example of the product code. In the schematic diagram, a portion composed of m columns x n lines represents a two-dimensional data packet. Referring to Fig. 17, a first correction code po is composed of q symbols x (n - p) lines. In addition, a second correction code pi is composed of m symbols x p lines.

Fig. 18 is a schematic diagram showing another example of the product code. Referring to Fig. 18, a portion composed of $\{m - (q + p)\}$ columns x n lines represents a two-dimensional data packet. In this example, a first correction code po is formed by diagonally scanning data that is composed of (m - p) columns x n lines. Thus, the first correction code po is composed of q symbols x n lines. In addition, a second correction code Pi is composed of p symbols x n lines.

In the product code composed of two error correction codes, since each data symbol is contained in two error correction codes, even if one error correction code cannot be corrected, when the other error correction code can be corrected, repeating correction can be performed corresponding to the corrected result. In addition, corresponding to one error correction code that cannot be corrected, a lost pointer of the other error correction code can be formed. Thus, even if there are many symbols to be corrected, lost error correction can be performed.

On the other hand, in the data interleaving system, since a burst error is dispersed, a correctable burst error can be increased. Thus, the data interleaving system has been used in most recording systems that are subject to burst errors.

However, in any of the product code forming system and the data interleaving system, the encoding device and the decoding device require memory and its control circuit suitable for the product code length and interleaving length, the construction of the devices that handle the long product code length and long interleaving length become complicated.

In other words, the conventional devices that form the product code involving the interleaving process perform error correction code encoding process based on large data packets as shown in Figs. 17 and 18. Thus, when such devices process video signals or the like on real time basis, they require memories that store next packet data while they are performing the error correction code encoding process. As with the encoding device, such a problem takes place in the decoding device.

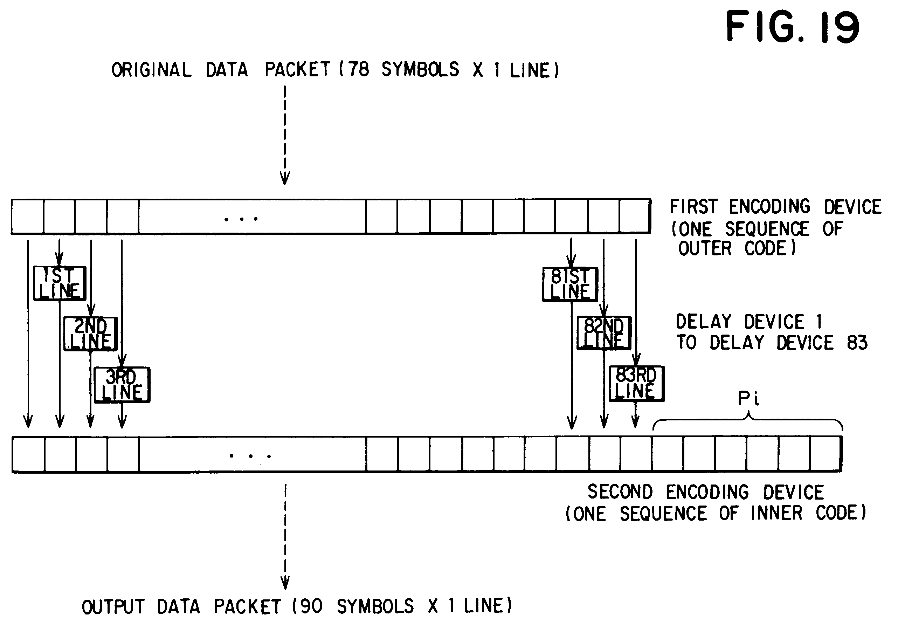

For example, in the case that the symbol length of the first error correction code sequence is 84 as shown in Fig. 19, the conventional product code forming device that involves the interleaving process should provide interleaving delay devices 1 to 83 that are disposed between the two error correction code forming devices so that the interleaving delay devices have different delay amounts. Thus, the number of delay devices to be used for the conventional devices is (symbol length of first error correction code sequence - 1). Consequently, codes with long code symbol length that has high error correction performance cannot be interleaved.

The present invention is made so as to solve the above-described problem. An object of the present invention is to provide an error correction code encoding device and an error correction code decoding device that have simple circuit construction for interleaving circuits and second encoding portions that are not largely affected by the product code length and interleaving length.

Another object of the present invention is to provide an error correction device and an error correction method that suppress the increase of the scale of the memory and control circuit of an encoding device and a decoding device even if the product code length and the interleave length increase.

To accomplish the above-described object, the present invention is an error correction code encoding device, comprising a first encoding means for adding first parity symbols composed of po symbols x n lines to an original data packet composed of (k x m - po) symbols x n lines and forming a first error correction code sequence composed of (k x m) symbols x n lines, where k, m, and n are any positive integers, po being a positive integer that is smaller than k x m, a block delay positioning means for dividing the matrix symbols of the first error correction code sequence formed by the first encoding means into k blocks, each of which is composed of m symbols x n lines, and positioning the k blocks as diagonal element blocks of a block matrix composed of k blocks x k lines, a means for controlling a first encoding process by the first encoding means and a block positioning process by the block delay positioning means for a plurality of original data packets to be transmitted in succession, a second encoding means for adding second parity symbols composed of pi symbols (where pi is any positive integer) x n lines to the matrix composed of (k x m) symbols x n lines that has been processed by the block delay positioning means and forming a second error correction code sequence composed of (k x m + pi) symbols x n lines, and an output means for successively outputting the matrix symbols of the second error correction code sequence formed by the second encoding means every (k x m + pi) symbols at a time for n lines in the line direction of the matrix symbols.

According to the present invention, the block delay positioning means divides matrix symbols of the first error correction code sequence into k blocks, each of which is composed of m columns x n lines. Thereafter, the block delay positioning means positions the k divided blocks as diagonal element blocks of a block matrix composed of k blocks x k lines.

The second encoding means adds the second parity symbols composed of pi symbols x n lines to the matrix composed of (k x m) symbols x n lines that have been processed by the block delay positioning means and forms the second error correction code sequence composed of (k x m + pi) symbols x n lines.

To accomplish the above-described object, the present invention is a device for decoding error correction codes encoded by an error correction code encoding device for adding first parity symbols composed of po symbols x n lines to an original data packet, each of which is composed of (k x m - po) symbols x n lines, and forming a first error correction code sequence composed of (k x m) symbols x n lines, where k, m, and n are any positive integers, po being a positive integer that is smaller than k x m, dividing the matrix symbols of the first error correction code sequence into k blocks, each of which is composed of m symbols x n lines, and positioning the k blocks as diagonal element blocks of a block matrix composed of k blocks x k lines, controlling a first encoding process and a block positioning process for a plurality of original data packets to be transmitted in succession, adding second parity symbols composed of pi symbols (where pi is any positive integer) x n lines to the matrix composed of (k x m) symbols x n lines and forming a second error correction code sequence composed of (k x m + pi) symbols x n lines, and successively outputting the matrix symbols of the second error correction code sequence every (k x m + pi) symbols at a time for n lines in the line direction of the matrix symbols, the decoding device comprising a first decoding means for receiving the last encoded packet data and decoding n sequences of the second error correction code sequence for every (k x m + pi) symbols at a time, a block delay means for dividing n lines of the last encoded packet data that have been successively received into k blocks, each of which is composed of m symbols x n lines, delaying the k blocks with different delay amounts, and obtaining n sequences of the first error correction code sequence, a second decoding means for decoding n sequences of the first error correction code sequence that have been obtained by the block delay means, and a control means for causing the second decoding means to decode the n sequences of the first error correction code sequence and the first decoding means to decode the n sequences of the second error correction code sequence.

According to the present invention, the first decoding means receives the last decoded packet data from the error correction code encoding device and decodes n sequences of the second error correction code sequence for every (k x m + pi) symbols at a time. The block delay means divides the last encoded packet data into k blocks, each of which is composed of m symbols x n lines and forms n sequences of the first error correction code sequence with difference delay amounts. The second decoding means decodes the n sequences of the first error correction code sequence. Last, the first decoding means decodes n sequences of the second correction code.

Thus, according to the present invention, since error correction codes in product code construction are encoded and decoded through an interleaving process that is performed for each block composed of m symbols x n lines, even if the product code length and the interleaving length are increased, the increase of the storage capacity of the memory and the control circuit for the encoding device and the decoding device can be effectively suppressed.

These and other objects, features and advantages of the present invention will become more apparent in light of the following detailed description of best mode embodiments thereof, as illustrated in the accompanying drawings.

Fig. 1 is a schematic diagram for explaining an embodiment of the present invention, the schematic diagram showing an original data packet that has not been encoded;

Fig. 2 is a schematic diagram showing a process for forming an outer code in an error correction process;

Fig. 3 is a schematic diagram showing a block interleaving process according to an embodiment of the present invention;

Fig. 4 is a schematic diagram showing an inner code forming process in the error correction process;

Fig. 5 is a block diagram showing the construction of an encoding device according to the embodiment of the present invention;

Fig. 6 is a schematic diagram showing the construction of last encoded packet data;

Fig. 7 is a block diagram showing a decoding device according to the embodiment of the present invention;

Fig. 8 is a schematic diagram showing the construction of a delay device (memory) used in the decoding device of Fig. 7;

Fig. 9 is a schematic diagram showing the construction of a delay device (memory) used in a decoding device according to another embodiment of the present invention;

Fig. 10 is a schematic diagram for explaining the operation of the delay device (memory) of Fig. 9;

Fig. 11 is a schematic diagram showing another data sequence of an original data packet matrix;

Fig. 12 is a schematic diagram showing an example of an outer code parity forming operation sequence;

Fig. 13 is a schematic diagram showing a block interleaving process of the outer code parity forming operation sequence of Fig. 12;

Fig. 14 is a schematic diagram showing another data sequence of the original data packet matrix;

Fig. 15 is a schematic diagram showing another example of the outer code parity forming operation sequence;

Fig. 16 is a schematic diagram showing the block interleaving process in the case that the outer code parity generation operation sequence of Fig. 15 is used;

Fig. 17 is a schematic diagram showing an example of a conventional product code;

Fig. 18 is a schematic diagram showing another example of the conventional product code; and

Fig. 19 is a schematic diagram for explaining the construction of a conventional encoding device.

Next, with reference to the accompanying drawings, an embodiment of the present invention will be described.

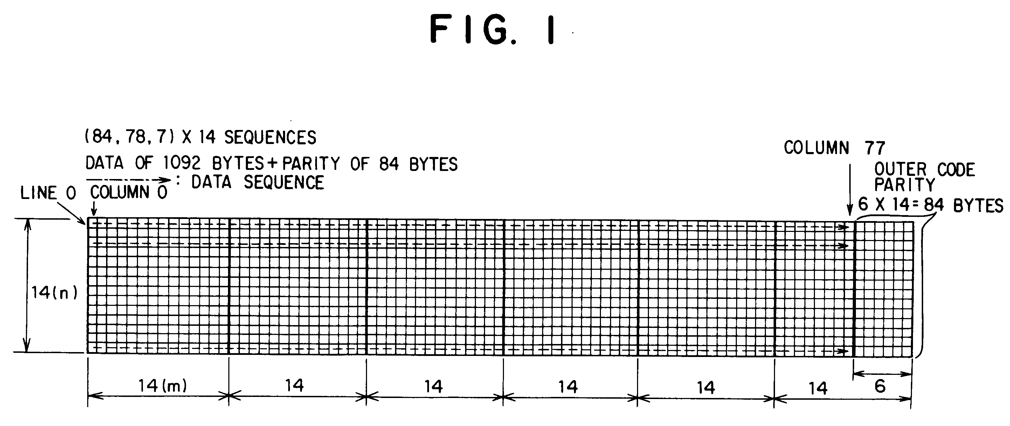

Fig. 1 is a schematic diagram showing an original data packet that has not been encoded. The original data packet is composed of (6 x 14 - 6) symbols x 14 lines. As denoted by arrows with dashed lines shown in Fig. 1, the data is positioned for 78 symbols from line 0, column 0 to line 1, column 77. Thereafter, the data is positioned for 86 symbols from line 1, column 0 to line 1, column 77. In such a manner, the data is successively positioned.

To the original data packet matrix, as a first encoding process, first parity symbols po is added. The first parity symbols po are composed of 6 symbols (that range from column 78 to column 83) x 14 lines. A first code is composed of 14 sequences of an outer code, each of which is composed of 84 symbols. The first code is composed of for example 14 sequences of Reed Solomon (84, 78, 7) code.

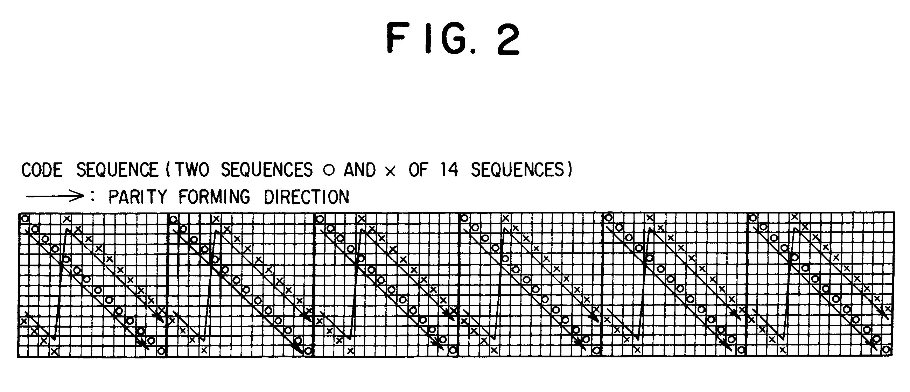

Fig. 2 is a schematic diagram showing a process for forming 14 sequences of an outer code. Now, assume that the first code matrix is composes of 84 symbols (that range from column 0 to column 83) x 14 lines (that range from line 0 to line 13). In addition, the line 14 is rotated as line 0. Thus, lines exceeding line 14 are handled in the first code matrix composed of 84 symbols x 14 lines. In the first code at line i ($0 \leq i \leq 13$), six first parity symbols are formed from 78 original data symbols that range from line i, column o to line (i + 77), column 77. The six first parity symbols are positioned as six symbols that range from line (i + 78), column 78 to line (i + 83), column 83.

Thus, as denoted by the arrows with dashed lines shown in Fig. 2, the arrows represent two types of sequences, 14 code sequences are formed by diagonally scanning a matrix composed of 84 symbols x 14 lines. In detail, all the 14 code sequences are repeatedly formed every 14 symbols that are equivalent to the number of lines of the matrix. To form a product code, a second code should be intersected with a first code. However, one symbol of the first code cannot be contained in one symbol of the second code.

To solve this problem, according to the embodiment of the present invention, a second code is intersected with a first code so as to form a product code. In addition, so as to improve a burst error correction performance, the first code is interleaved. In this case, since each of 14 sequences of the first code is periodically scanned every 14 symbols that are equivalent to the number of lines of the matrix, the matrix is interleaved as blocks, each of which is composed of 14 lines x 14 columns.

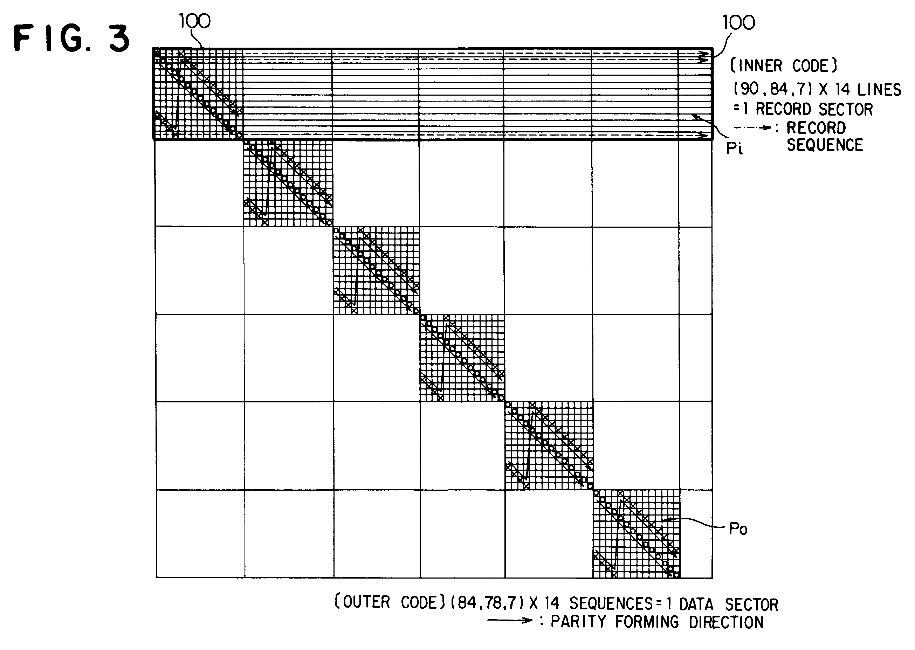

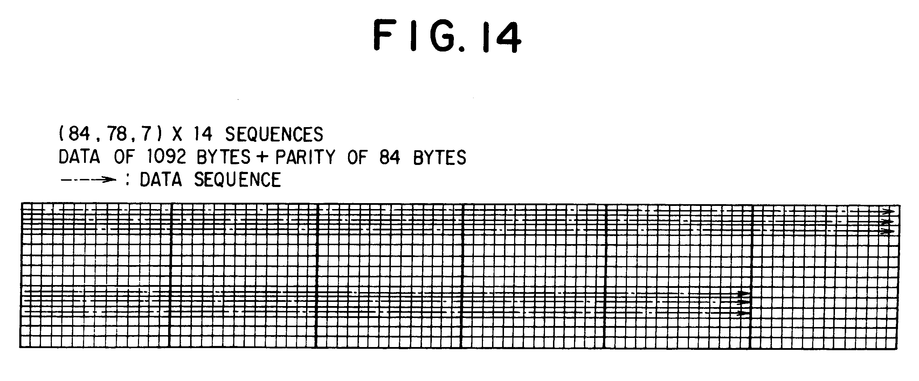

In other words, as shown in Fig. 3, 14 sequences of the outer code that are composed of 84 symbols x 14 lines are divided into six blocks, each of which is composed of 14 symbols x 14 lines. Thereafter, the divided six blocks are delayed by a plurality of delay devices with different delay amounts. A block that includes column 0 is positioned as a first block that is one diagonal element block at the upper left position of a block matrix composed of 6 blocks x 6 lines.

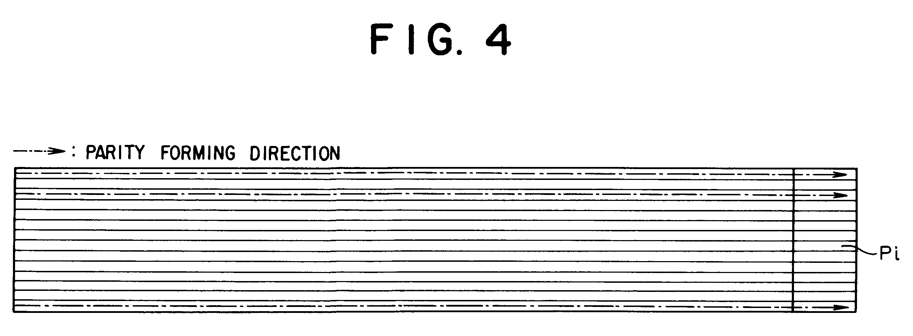

Thereafter, the first encoding process and block delay positioning process are performed for a plurality of original data packets to be successively transmitted. In addition, a second parity symbol (inner code parity) pi composed of 6 symbols x 14 lines is added to the matrix composed of (6 x 14) symbols x 14 lines. Thus, an inner code (second error correction code sequence) sequence composed of (6 x 14 + 6) symbols x 14 lines is formed. The second error correction code sequence (inner code) sequence is denoted by a frame 100 composed of 90 symbols x 14 lines as shown in Fig. 3. The frame 100 is composed of for example 14 sequences of Reed Solomon (90, 80, 7) code. As shown in Fig. 4, since this operation is performed for each line, the 14 lines of the original data packet can be sequentially transmitted as last encoded packet data.

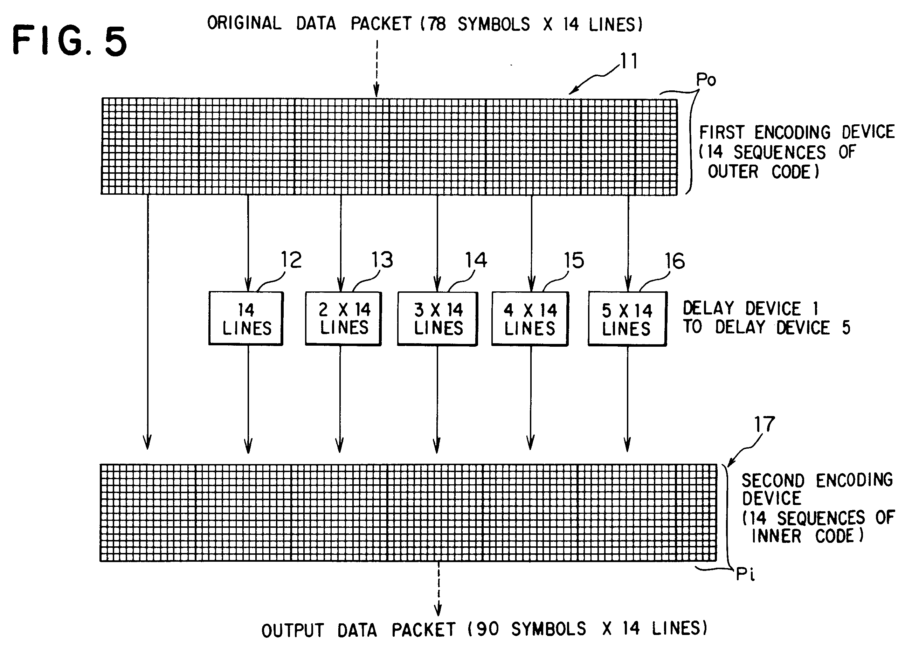

Fig. 5 is a schematic diagram showing a construction of a device that performs the above-described first encoding process, which formes the outer code, and the second encoding process, which forms the inner code.

Referring to Fig. 5, the device comprises a first encoding device 11, a plurality of (for example, five) delay devices 12, 13, 14, 15, and 16, and a second encoding device 17. Original data packets, each of which is composed of 78 symbols x 14 lines as shown in Fig. 1, are successively input to the first encoding device 11, packet by packet. The first encoding device 11 performs a diagonally scanning operation for the original symbol matrix corresponding to the first encoding process and forms an outer code parity po composed of 6 columns x 14 lines. In addition, the first encoding device 11 adds the outer code parity po to the original data packet and forms an outer code composed of 84 columns x 14 lines.

Moreover, the first encoding device divides the outer code into six blocks 0 to 5, each of which is composed of 14 columns x 14 lines, and supplies the divided blocks to the delay devices 12, 13, 14, 15, and 16 with delay amounts that are block numbers x 14 lines. In reality, since the delay amount of block number 0 is 0, only five delay devices are shown in Fig. 5.

The six blocks that are output from the delay devices each contain one of six blocks of the outer code. It is clear that the symbol matrix composed of the six blocks is the same as the matrix composed of 84 columns x 14 lines in which the six sequences of the outer code have been block-interleaved as shown in Fig. 3.

The symbol matrix composed of 84 columns x 14 lines is input to the second encoding device 17. The second encoding device 17 performs a line-directional operation for the symbol matrix corresponding to the second encoding process and adds the inner code parity pi composed of 6 columns x 14 lines to the symbol matrix. Thus, an inner code composed of 90 columns x 14 lines is formed.

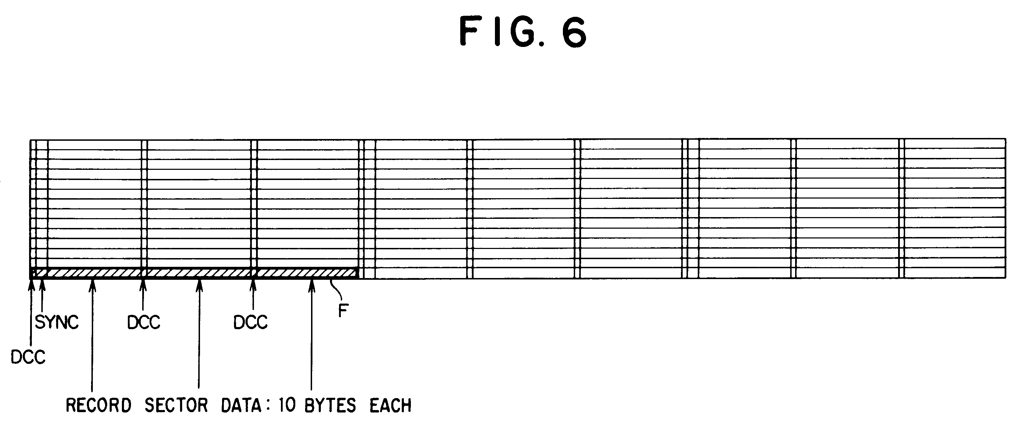

In this embodiment, as shown in Fig. 6, 90 symbols for each line of the inner code are divided by 3 so as to form three synchronous frames F (denoted as hatched portions in Fig. 6). The synchronous frames F contain frame synchronous signals (DCC + SYNC). The frame synchronous signals are positioned at the beginning of the synchronous frames F.

Next, a device that decodes data that has been encoded with error correction codes by the error correction code encoding device will be described.

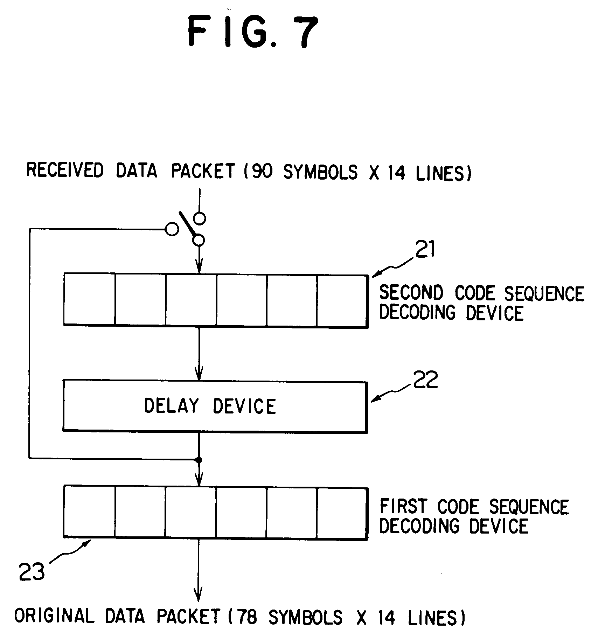

Fig. 7 is a block diagram showing the construction of the decoding device. Referring to Fig. 7, the decoding device comprises a second code (inner code) decoding device 21, a delay device (memory) 22, and a first code (outer code) decoding device 23.

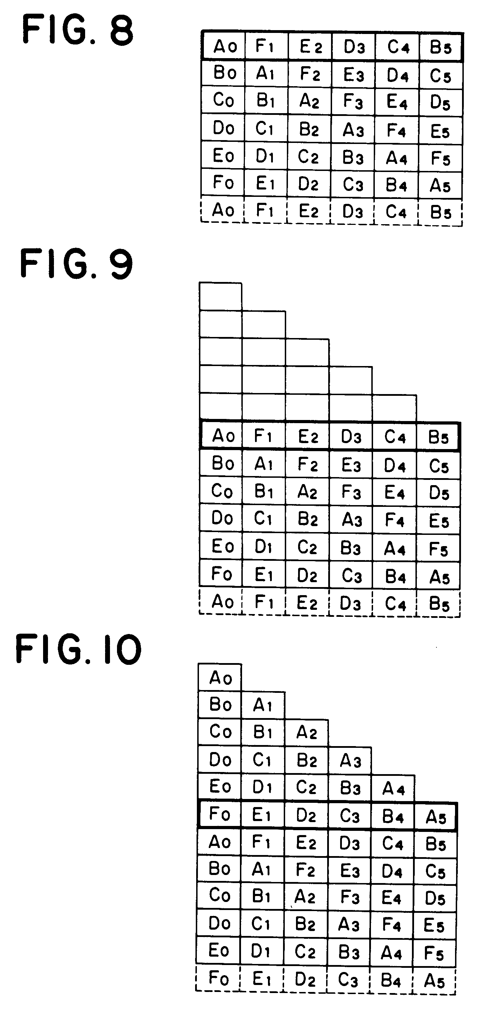

Data that is output from the error correction code encoding device is received by the decoding device through for example a communication line. The received data is input to the delay device (memory) formed in a matrix shape as shown in Fig. 8. The sequences of the first code are identified by alphabetical letters A, B, C, D, E, and F. On the other hand, the blocks of the first code are identified by numerals 0 to 5. Six blocks A0, F1, E2, D3, C4, and B5 of line 1 of Fig. 8 that are surrounded by thick lines are first packet data that is composed of 90 symbols x 14 lines. Thereafter, second packet data, third packet data, and so forth that are received are input to the second line, the third line, and so forth.

The second code decoding device 21 decodes the second code (inner code) every packet data composed of 90 symbols x 14 lines and outputs a symbol matrix composed of 84 symbols x 14 lines. After the line 6 of the second code (namely, sixth packet) has been decoded, the decoding device 23 decodes the first code (outer code). In other words, the decoding device 23 decodes the outer code composed of blocks A0, A1, A2, A3, A4, and A5 that are composed of 84 symbols x 14 lines.

In the real operation, while data is being decoded, packet data composed of 90 symbols x 14 lines denoted by dashed lines of Fig. 8 is input to the second code decoding device 21. Thus, the delay device (memory) 22 requires the storage capacity for 6 blocks x (6 lines + 1 line).

After 14 sequences of the outer code composed of blocks A0, A1, A2, A3, A4, and A5 have been decoded, the second code decoding device 21 decodes 14 sequences of the second code (inner code). Thus, code words that have not been corrected in the second code (inner code) decoding process and the first code (outer code) decoding process are corrected. Last, the original data packet is extracted from the matrix composed of the blocks A0, A1, A2, A3, and A4.

The delay device (memory) 22 can be shared between the encoding process and the decoding process.

As described above, according to the embodiment of the present invention, even if the product code length and the interleaving length are increased for improving the error correction performance, the amount of the memory and the scale of control circuit for the encoding device and the decoding device can be effectively reduced.

Next, an decoding device according to another embodiment of the present invention will be described. In the decoding device, a third decoding process is more securely performed than that of the above-described embodiment.

In the decoding device according to this embodiment, packet data composed of 90 symbols x 14 lines is input to a delay device (memory) that has a storage capacity of (6 blocks x 7 lines + 15 blocks) as shown in Fig. 9. In Fig. 9, blocks A0, F1, E2, D3, C4, and B5 that are denoted by dashed lines are packet data that has been received first time. After one line of the packet data has been written, it is shifted upward for one line and the next six blocks are written to the portion denoted by the dashed lines.

The second code decoding device decodes a second code (inner codes) every packet data that is composed of 90 symbols x 14 lines and forms a symbol matrix that is composed of 84 symbols x 14 lines. After line 6 of the second code (namely, sixth packet data) has been decoded, a first code (outer code) is decoded. In other words, the outer code composed of blocks A0, A1, A2, A3, A4, and A5 that are composed of 84 symbols x 14 lines are decoded.

In the real operation, while data is being decoded, packet data composed of 90 symbols x 14 lines is newly input.

After the 14 sequences of the outer code composed of blocks A0, A1, A2, A3, A4, and A5 have been decoded, the 14 sequences of the second code (inner code) denoted by thick lines of Fig. 9 are decoded as a third decoding process. Thus, code words that have not been corrected by the second code decoding process and the first code decoding process are corrected.

After the third decoding process has been completed, each line is shifted upward for one line and newly received data is written to the portion denoted by the dashed line of Fig. 9. When such an operation is performed six times for six blocks, each block is positioned in the delay device (memory) as shown in Fig. 10. Last, the original data packet composed of 78 symbols x 14 lines is extracted from the matrix of the blocks A0, A1, A2, A3, A4, and A5.

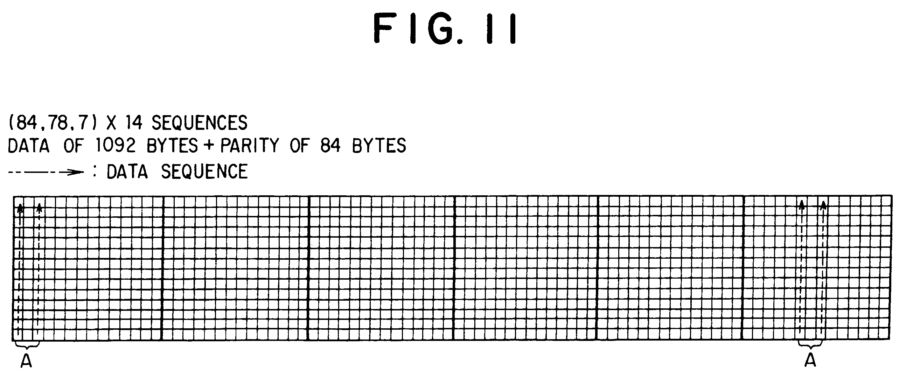

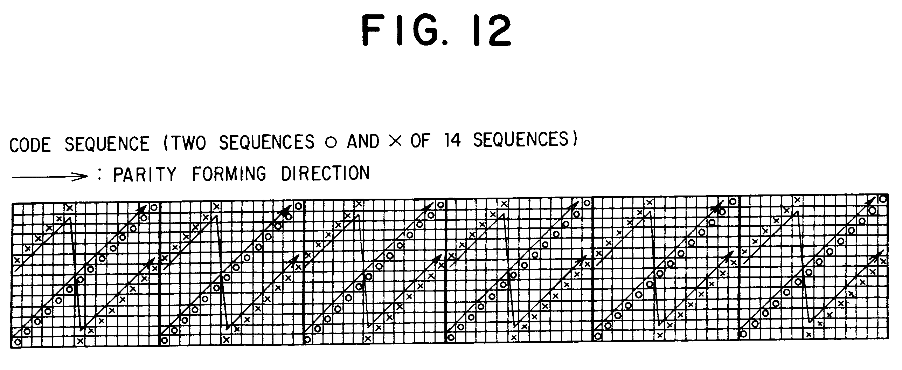

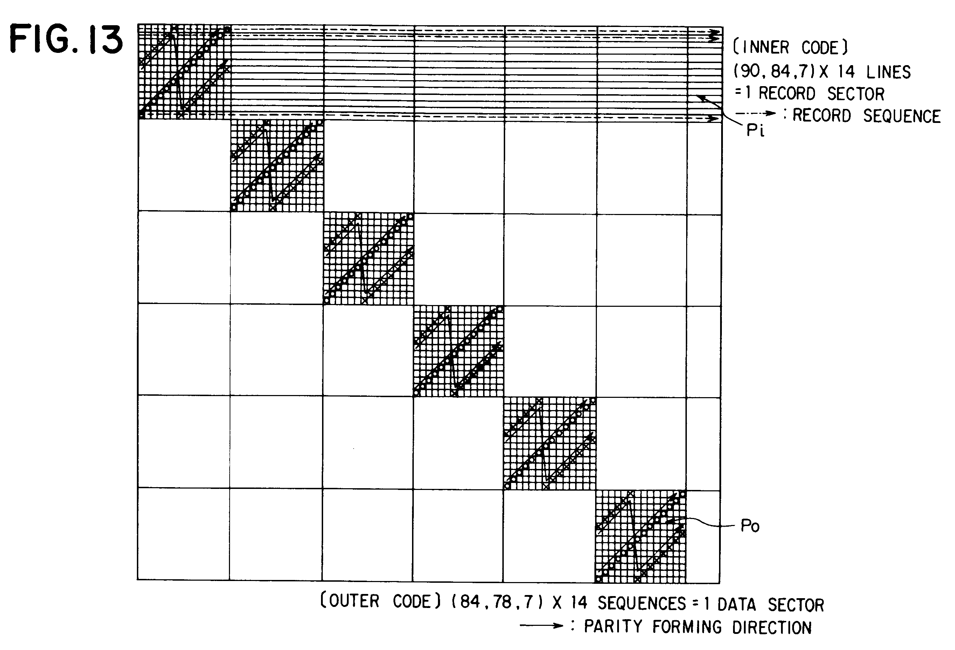

As shown in Fig. 11, data of original data packet matrix that is composed of 78 symbols x 14 lines and that has not been encoded may be positioned in the order of line 13 to line 0 of each column as denoted by arrows A with dashed lines of Fig. 11. Alternatively, the data may be position in the order of line 0 to line 13 of each column. As a further alternative manner, as shown in Fig. 12, the direction of the parity forming operation of the outer code composed of 6 symbols x 14 lines by the first encoding device 11 may be a diagonal direction in the reverse direction of Fig. 2. Fig. 13 is a schematic diagram showing a block interleaving process in this case. The block interleaving process in this case is basically the same as that of the above-described embodiment.

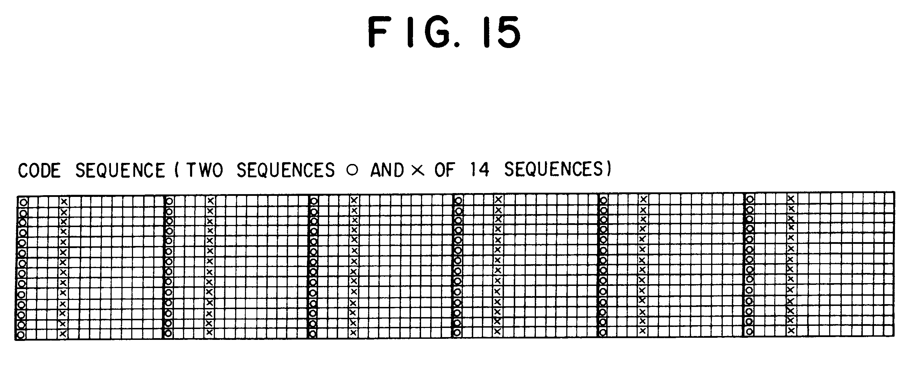

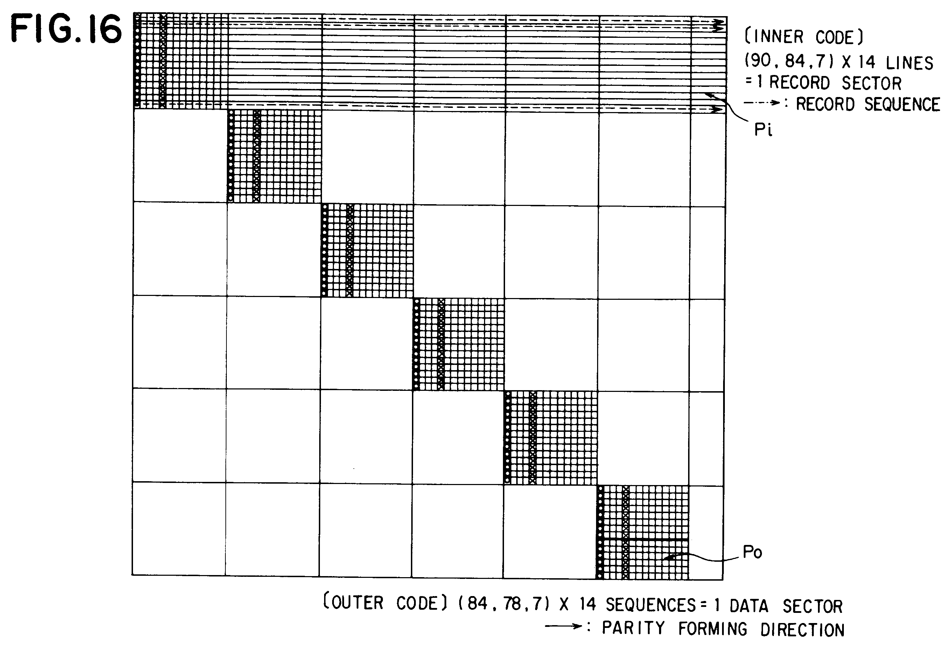

As a further embodiment, as shown in Fig. 14, 1092 symbols of an original data packet composed of 78 symbols x 14 lines may be positioned in the outer code composed of 84 symbols x 14 lines in such a manner that 84 symbols are positioned in the order of column 0 to column 83 for each of line 0 to line 7 and 70 symbols are positioned in the order of column 0 to column 69 for each of line 8 to line 13. Alternatively, 196 symbols are positioned in the order of column 0 to column 13 for each of line 0 to 14 for the first five blocks and 112 symbols are positioned in the order of column 0 to column 13 for each of line 0 to line 7 for the last block. In this case, the present invention can be applied. In this case, the outer code parity forming operation is performed in the direction of the columns of the data as shown in Fig. 15 so that 14 sequences of the outer code parity by the first encoding device 11 are added to the first block composed of 6 symbols x 14 lines. Fig. 16 shows the block interleaving process in this case. The block interleaving process in this case is the same as that of the above-described embodiment.

As described above, according to the present invention, the interleaving circuit and the second encoding circuit can be simplified without being affected by the product code length and the interleaving length.

Although the present invention has been shown and described with respect to best mode embodiments thereof, it should be understood by those skilled in the art that the foregoing and various other changes, omissions, and additions in the form and detail thereof may be made therein without departing from the spirit and scope of the present invention.

**Claims**

1. An error correction code encoding device, comprising:

   first encoding means for adding first parity symbols composed of po symbols x n lines to an original data packet composed of (k x m - po) symbols x n lines and forming a first error correction code sequence composed of (k x m) symbols x n lines, where k, m, and n are any positive integers, po being a positive integer that is smaller than k x m,

   block delay positioning means for dividing the matrix symbols of the first error correction code sequence formed by said first encoding means into k blocks, each of which is composed of m symbols x n lines, and positioning the k blocks as diagonal element blocks of a block matrix composed of k blocks x k lines;

means for successively controlling a first encoding process by said first encoding means and a block positioning process by said block delay positioning means for a plurality of original data packets to be transmitted in succession;

second encoding means for adding second parity symbols composed of pi symbols (where pi is any positive integer) x n lines to the matrix composed of (k x m) symbols x n lines that has been processed by said block delay positioning means and forming a second error correction code sequence composed of (k x m + pi) symbols x n lines; and

output means for successively outputting the matrix symbols of the second error correction code sequence formed by said second encoding means every (k x m + pi) symbols at a time for n lines in the line direction of the matrix symbols.

2. The error correction code encoding device as set forth in claim 1,

wherein a symbol group composing the original packet data is successively positioned in the line direction thereof.

3. The error correction code encoding device as set forth in claim 1,

wherein a symbol group composing the original packet data is successive positioned in the column direction thereof.

4. The error correction code encoding device as set forth in claim 1,

wherein the symbols of the original packet data are positioned in the line direction [m symbols x n lines x {(k x m - po) / m}] times and in the column direction [{(k x m - po) mod m} symbols x n lines x 1}] times.

5. The error correction code encoding device as set forth in claim 1,

wherein said first encoding means is adapted for rotating and positioning line 0 to a line equivalent to line number n and forming a ring-shaped matrix so as to handle lines larger than the line n, forming po first parity symbols from (k x m - po) original data symbols in the range from line i, column o to line (i + k x m - po - 1), column (k x m - po - 1), and positioning po symbols from line (i + k x m - po), column (k x m - po) to line (i + k x m - 1),

column (k x m - 1), where the matrix composed of (k x m) symbols x n lines contains the original data packet matrix at the left end thereof and ranges from line 0 to line (n - 1) and from column 0 to column (k x m - 1).

6. The error correction code encoding device as set forth in claim 1,

wherein said first encoding means is adapted for transforming each symbol that is a matrix element of (k x m) symbols x n lines containing the original data packet matrix at the left end thereof into a transform matrix composed of n lines of the first error correction code sequence so that one line composes one sequence of the first error correction code sequence, adding po first parity symbols to each line of the transform matrix, and retransforming the resultant matrix into the original matrix composed of (k x m) symbols x n lines.

7. The error correction code encoding device as set forth in claim 1,

wherein said second encoding means is adapted for adding pi second parity symbols to each line of the (k x m) symbols x n lines of the block delay positioning process by said block delay positioning means.

8. The error correction code encoding device as set forth in claim 1,

wherein the first error correction code sequence is composed of (k x m) symbols x n lines, where m is equal to n.

9. The error correction code encoding device as set forth in claim 8,

wherein symbols of the original packet data are positioned in the line direction [n symbols x n lines x {(k x n - po)} / n] times and in the column direction [n symbols x {(k x n - po) mod n} lines x 1] times.

10. The error correction code encoding device as set forth in claim 8,

wherein said first encoding means is adapted for forming an i-th first error correction code sequence as a code word containing po first parity symbols after (k x n) symbols ranging from column i, line o to column (j x n + 1), line (n - 1), where j is in the range from 1 to (k - 1), when the matrix composed of (k x n) symbols x n lines that contains the original data packet matrix composed of (k x n - po) symbols x n lines at the left end thereof ranges from line o to line (n - 1) and from column o to column (k x n - 1).

11. The error correction code encoding device as set forth in claim 1,

wherein said output means is adapted for forming a synchronous frame with the length of 1 / n of (k x m + pi) symbols that is the code length of one sequence of the second error correction code sequence.

12. The error correction code encoding device as set forth in claim 1,

wherein all the lines are substituted with all the columns.

13. An error correction code encoding method, comprising the steps of:

adding first parity symbols composed of po symbols x n lines to a plurality of original data packets, each of which is successively-transmitted and composed of (k x m - po) symbols x n lines, and forming a first error correction code sequence composed of (k x m) symbols x n lines, where k, m, and n are any positive integers, po being a positive integer that is smaller than k x m,

dividing the matrix symbols of the first error correction code sequence formed by said first encoding step into k blocks, each of which is composed of m symbols x n lines, and positioning the k blocks as diagonal element blocks of a block matrix composed of k blocks x k lines;

successively controlling a first encoding process by said first encoding step and a block positioning process by said block delay positioning step for a plurality of original data packets to be transmitted in succession;

adding second parity symbols composed of pi symbols (where pi is any positive integer) x n lines to the matrix composed of (k x m) symbols x n lines that has been processed by said block delay positioning step and forming a second error correction code sequence composed of (k x m + pi) symbols x n lines; and

successively outputting the matrix symbols of the second error correction code sequence formed by said second encoding step every (k x m + pi) symbols at a time for n lines in the line direction of the matrix symbols.

14. A device for decoding error correction codes encoded by an error correction code encoding device for adding first parity symbols composed of po symbols x n lines to an original data packet, each of which is composed of (k x m - po) symbols x n lines, and forming a first error correction code sequence composed of (k x m) symbols x n lines, where k, m, and n are any positive integers, po being a positive integer that is smaller than k x m;

dividing the matrix symbols of the first error correction code sequence into k blocks, each of which is composed of m symbols x n lines, and positioning the k blocks as diagonal element blocks of a block matrix composed of k blocks x k lines;

successively controlling a first encoding process and a block positioning process for a plurality of original data packets to be transmitted in succession;

adding second parity symbols composed of pi symbols (where pi is any positive integer) x n lines to the matrix composed of (k x m) symbols x n lines and forming a second error correction code sequence composed of (k x m + pi) symbols x n lines; and

successively outputting the matrix symbols of the second error correction code sequence every (k x m + pi) symbols at a time for n lines in the line direction of the matrix symbols, said decoding device comprising:

first decoding means for receiving the last encoded packet data and decoding n sequences of the second error correction code sequence for every (k x m + pi) symbols at a time;

block delay means for dividing n lines of the last encoded packet data that have been successively received into k blocks, each of which is composed of m symbols x n lines, delaying the k blocks with different delay amounts, and obtaining n sequences of the first error correction code sequence; and

second decoding means for decoding n sequences of the first error correction code sequence that have been obtained by said block delay means.

15. A device for decoding error correction codes encoded by an error correction code encoding device for adding first parity symbols composed of po symbols x n lines to an original data packet, each of which is composed of (k x m - po) symbols x n lines, and forming a first error correction code sequence composed of (k x m) symbols x n lines, where k, m, and n are any positive integers, po being a positive integer that is smaller than k x m;

dividing the matrix symbols of the first error correction code sequence into k blocks, each of which is composed of m symbols x n lines, and positioning the k blocks as diagonal element blocks of a block matrix composed of k blocks x k lines;

successively controlling a first encoding process and a block positioning process for a plurality of original data packets to be transmitted in succession;

adding second parity symbols composed of pi symbols (where pi is any positive integer) x n lines to the matrix composed of (k x m) symbols x n lines and forming a second error correction code sequence composed of (k x m + pi) symbols x n lines; and

successively outputting the matrix symbols of the second error correction code sequence every (k x m + pi) symbols at a time for n lines in the line direction of the matrix symbols, said decoding device comprising:

first decoding means for receiving the last encoded packet data and decoding n sequences of the second error correction code sequence for every (k x m + pi) symbols at a time;

block delay means for dividing n lines of the last encoded packet data that have been successively received into k blocks, each of which is composed of m symbols x n lines, delaying the k blocks with different delay amounts, and obtaining n sequences of the first error correction code sequence;

second decoding means for decoding n sequences of the first error correction code sequence that have been obtained by said block delay means; and

control means for causing said second decoding means to decode the n sequences of the first error correction code sequence and said first decoding means to decode the n sequences of the second error correction code sequence.

16. A method for decoding error correction codes encoded by an error correction code encoding device for

adding first parity symbols composed of po symbols x n lines to an original data packet, each of which is composed of (k x m - po) symbols x n lines, and forming a first error correction code sequence composed of (k x m) symbols x n lines, where k, m, and n are any positive integers, po being a positive integer that is smaller than k x m;

dividing the matrix symbols of the first error correction code sequence into k blocks, each of which is composed of m symbols x n lines, and positioning the k blocks as diagonal element blocks of a block matrix composed of k blocks x k lines;

successively controlling a first encoding process and a block positioning process for a plurality of original data packets to be transmitted in succession;

adding second parity symbols composed of pi symbols (where pi is any positive integer) x n lines to the matrix composed of (k x m) symbols x n lines and forming a second error correction code sequence composed of (k x m + pi) symbols x n lines; and

successively outputting the matrix symbols of the second error correction code sequence every (k x m + pi) symbols at a time for n lines in the line direction of the matrix symbols, said decoding method comprising the steps of:

receiving the last encoded packet data and decoding n sequences of the second error correction code sequence for every (k x m + pi) symbols at a time;

dividing n lines of the last encoded packet data that have been successively received into k blocks, each of which is composed of m symbols x n lines, delaying the k blocks with different delay amounts, and obtaining n sequences of the first error correction code sequence; and

decoding n sequences of the first error correction code sequence that have been obtained by said block delay means.

17. A method for decoding error correction codes encoded by an error correction code encoding device for

adding first parity symbols composed of po symbols x n lines to an original data packet, each of which is composed of (k x m - po) symbols x n lines, and forming a first error correction code sequence composed of (k x m) symbols x n lines, where k, m, and n are any positive integers, po being a positive integer that is smaller than k x m;

dividing the matrix symbols of the first error correction code sequence into k blocks, each of which is composed of m symbols x n lines, and positioning the k blocks as diagonal element blocks of a block matrix composed of k blocks x k lines;

successively controlling a first encoding process and a block positioning process for a plurality of original data packets to be transmitted in succession;

adding second parity symbols composed of pi symbols (where pi is any positive integer) x n lines to the matrix composed of (k x m) symbols x n lines and forming a second error correction code sequence composed of (k x m + pi) symbols x n lines; and

successively outputting the matrix symbols of the second error correction code sequence every (k x m + pi) symbols at a time for n lines in the line direction of the matrix symbols, said decoding method comprising the steps of:

receiving the last encoded packet data and decoding n sequences of the second error correction code sequence for every (k x m + pi) symbols at a time;

dividing n lines of the last encoded packet data that have been successively received into k blocks, each of which is composed of m symbols x n lines, delaying the k blocks with different delay amounts, and obtaining n sequences of the first error correction code sequence;

decoding n sequences of the first error correction code sequence that have been obtained by said block delay means; and

causing said second decoding means to decode the n sequences of the first error correction code sequence and said first decoding means to decode the n sequences of the second error correction code sequence.

# FIG. 1

(84, 78, 7) X 14 SEQUENCES

DATA OF 1092 BYTES + PARITY OF 84 BYTES

———————→ : DATA SEQUENCE

LINE 0  COLUMN 0

COLUMN 77

OUTER CODE PARITY

6 X 14 = 84 BYTES

14(n)

14(m)    14    14    14    14    14    6

EP 0 674 395 A2

# FIG. 2

CODE SEQUENCE (TWO SEQUENCES ○ AND × OF 14 SEQUENCES)

→ : PARITY FORMING DIRECTION

# FIG. 3

(INNER CODE)
(90,84,7) X 14 LINES
=1 RECORD SECTOR
---→: RECORD
      SEQUENCE

100

100

Pi

Po

(OUTER CODE)(84,78,7) X 14 SEQUENCES=1 DATA SECTOR
          ——→ : PARITY FORMING DIRECTION

EP 0 674 395 A2

# FIG. 4

- - - → : PARITY FORMING DIRECTION

Pi

EP 0 674 395 A2

# FIG. 5

ORIGINAL DATA PACKET (78 SYMBOLS X 14 LINES)

11

Po

FIRST ENCODING DEVICE
(14 SEQUENCES OF
OUTER CODE)

| 12 | 13 | 14 | 15 | 16 |
|---|---|---|---|---|
| 14 LINES | 2 X 14 LINES | 3 X 14 LINES | 4 X 14 LINES | 5 X 14 LINES |

DELAY DEVICE 1
TO DELAY DEVICE 5

17

SECOND ENCODING
DEVICE
(14 SEQUENCES OF
INNER CODE)

Pi

OUTPUT DATA PACKET (90 SYMBOLS X 14 LINES)

EP 0 674 395 A2

# FIG. 6

RECORD SECTOR DATA: 10 BYTES EACH

EP 0 674 395 A2

# F I G. 7

RECEIVED DATA PACKET (90 SYMBOLS X 14 LINES)

SECOND CODE SEQUENCE DECODING DEVICE 21

DELAY DEVICE 22

FIRST CODE SEQUENCE DECODING DEVICE

23

ORIGINAL DATA PACKET (78 SYMBOLS X 14 LINES)

## FIG. 8

| Ao | F1 | E2 | D3 | C4 | B5 |
|----|----|----|----|----|----|
| Bo | A1 | F2 | E3 | D4 | C5 |
| Co | B1 | A2 | F3 | E4 | D5 |
| Do | C1 | B2 | A3 | F4 | E5 |
| Eo | D1 | C2 | B3 | A4 | F5 |
| Fo | E1 | D2 | C3 | B4 | A5 |
| Ao | F1 | E2 | D3 | C4 | B5 |

## FIG. 9

| Ao | F1 | E2 | D3 | C4 | B5 |
|----|----|----|----|----|----|
| Bo | A1 | F2 | E3 | D4 | C5 |
| Co | B1 | A2 | F3 | E4 | D5 |
| Do | C1 | B2 | A3 | F4 | E5 |
| Eo | D1 | C2 | B3 | A4 | F5 |
| Fo | E1 | D2 | C3 | B4 | A5 |
| Ao | F1 | E2 | D3 | C4 | B5 |

## FIG. 10

| Ao |    |    |    |    |    |
|----|----|----|----|----|----|
| Bo | A1 |    |    |    |    |
| Co | B1 | A2 |    |    |    |
| Do | C1 | B2 | A3 |    |    |
| Eo | D1 | C2 | B3 | A4 |    |
| Fo | E1 | D2 | C3 | B4 | A5 |
| Ao | F1 | E2 | D3 | C4 | B5 |
| Bo | A1 | F2 | E3 | D4 | C5 |
| Co | B1 | A2 | F3 | E4 | D5 |
| Do | C1 | B2 | A3 | F4 | E5 |
| Eo | D1 | C2 | B3 | A4 | F5 |
| Fo | E1 | D2 | C3 | B4 | A5 |

# FIG. 11

(84,78,7) X 14 SEQUENCES
DATA OF 1092 BYTES + PARITY OF 84 BYTES
-----> : DATA SEQUENCE

EP 0 674 395 A2

# FIG. 12

CODE SEQUENCE (TWO SEQUENCES ○ AND × OF 14 SEQUENCES)

⟶ : PARITY FORMING DIRECTION

EP 0 674 395 A2

# FIG.13

[INNER CODE]
(90, 84, 7) X 14 LINES
= 1 RECORD SECTOR
---→ : RECORD SEQUENCE
Pi

Po

(OUTER CODE) (84, 78, 7) X 14 SEQUENCES = 1 DATA SECTOR
——→ : PARITY FORMING DIRECTION

# FIG. 14

(84, 78, 7) X 14 SEQUENCES
DATA OF 1092 BYTES + PARITY OF 84 BYTES
——→ : DATA SEQUENCE

FIG. 15

CODE SEQUENCE (TWO SEQUENCES ○ AND × OF 14 SEQUENCES)

# FIG.16

(INNER CODE)
(90, 84, 7) X 14 LINES
= 1 RECORD SECTOR
---►: RECORD SEQUENCE

Pi

Po

(OUTER CODE) (84, 78, 7) X 14 SEQUENCES = 1 DATA SECTOR
———►: PARITY FORMING DIRECTION

EP 0 674 395 A2

# F I G. 17

m

m − q

q

n

n − p

p

Q
SEQUENCE

Po

P
SEQUENCE

Pi

FIRST CORRECTION
CODE WORD

SECOND CORRECTION
CODE WORD

# F I G. 18

m × k

Pi
SEQUENCE

Po
SEQUENCE

n × L

Po

Pi

84

m −(q + p)

q

p

78

6

6

90

# FIG. 19

ORIGINAL DATA PACKET (78 SYMBOLS X 1 LINE)

FIRST ENCODING DEVICE
(ONE SEQUENCE OF
OUTER CODE)

1ST LINE

81ST LINE

2ND LINE

82ND LINE

DELAY DEVICE 1
TO DELAY DEVICE 83

3RD LINE

83RD LINE

Pi

SECOND ENCODING DEVICE
(ONE SEQUENCE OF INNER CODE)

OUTPUT DATA PACKET (90 SYMBOLS X 1 LINE)

EP 0 674 395 A2